# EUROPEAN PATENT APPLICATION

(11) **EP 0 802 709 A1**
(43) Date of publication of application: **22.10.1997**
(21) Application number: 94912711.2
(22) Date of filing: 17.03.1994
(51) Int. Cl.: H05K 9/00, G12B 17/02

(54) **MATERIAL PROVIDING PROTECTION FROM RADIATION**

(30) Priority: 06.09.1993 WO PCT/RU93/00214
(71) Applicant: Kapitonov, Vladimir Ivanovich, Moscow, 107014 (RU); Mareichev, Anatoly Vasilievich, Moscow 127562 (RU)
(72) Inventor: Kapitonov, Vladimir Ivanovich, Moscow, 107014 (RU); Mareichev, Anatoly Vasilievich, Moscow 127562 (RU)
(74) Representative: W.P. Thompson & Co.
(86) International application number: RU9400052
(87) International publication number: WO9507602

(57) **Abstract**

The material comprises a nonmetallic base provided with a current-conducting coating applied thereto and consisting of at least one nonmetallic conducting layer and one metallic conducting layer, the innermost layer being a nonmetallic one. When more than two current-conducting layers are provided, various combinations of their arrangement in the coating and of their composition are possible, e.g., of metals or alloys thereof.

## Description

### Technical Field

The present invention relates in general to radiation protection means and more specifically to a material affording protection against radiations.

### Background Art

One state-of-the-art material for protection against radiations of, e.g., electromagnetic nature is known (US, A, 2,996,710) to comprise a dielectric base or matrix of, for instance, neoprene to which a metallic layer is applied, nickel being used as the metal involved.

However, the aforesaid material cannot be used, when of low thickness values, for reliable shielding of sources of electromagnetic radiation having frequencies below 10 MHz due to poorly manifested magnetic properties of the protective coating.

One more prior-art material for protection against electromagnetic-nature radiations is known (US, A, 4,439,768) to comprise a dielectric base in the form of a textile fabric provided with a current-conducting metallic coating of, e.g., nickel.

However, the aforesaid material, when of low thickness values, can afford but a low electromagnetic-field attenuation in the frequency range of from 0.1 to 5 MHz due to poor magnetic properties of the coating.

### Disclosure of the Invention

The present invention has for its principal object to provide a material for radiation protection having such a composition of the protective coating that assures a combination of high magnetic and electric components of the characteristics of said material, and a minimized coating weight, this being due to the provision of a metallic layer featuring high magnetic properties, as well as due to alternating coating layers having a high and a low electric resistance.

The foregoing object is accomplished due to the fact that in a material for radiation protection, comprising a nonmetallic base provided with a current-conducting coating applied thereto, according to the invention, the current-conducting coating comprises at least one nonmetallic current-conducting layer and one metallic current-conducting layer, the nonmetallic layer being the one immediately contacting the nonmetallic base of the coating.

Use in said coating of a nonmetallic current-conducting layer having a relatively high electric resistance, in conjunction with a low-Ohmic metallic layer makes it possible to increase much the protective properties of the proposed material on a broad range of radiation frequencies.

It is expedient, when using the proposed material for affording protection against soft X-rays, that the current-conducting coating comprises additionally a nonmetallic nonconducting layer which is in fact the outermost coating layer made of a dielectric material. In addition, said additional layer adds to the corrosion- and mechanical resistance of the material by imparting thereto dust- and moisture-proofness and electric-insulating properties.

It is preferable that the innermost nonmetallic current-conducting layer of the coating comprises the compounds of sulfides of metals selected from Groups I, II, III, IV, V, VI, VII, and VIII of the Periodic system. It is such a composition of said layer that provides for a preset electric resistance uniform over the entire layer, thus making it possible to increase the radiation-absorbing properties of the material and at the same time to ensure high strength of its adhesion to the nonmetallic base.

It is favorable that, when two or more nonmetallic current-conducting layers are provided in the coating, said layers, save the innermost one, comprise metal oxides selected from the group consisting of copper, silver, tin, bismuth, lead, nickel, cobalt, iron, chromium, aluminium, manganese, indium, zinc, and antimony.

Use of the aforesaid oxides in the proposed coating favors an additional radiation-absorbing effect, as well as corrosion protection of the material, imparting glareabsorbing properties thereto when said oxides are used in the outermost layer of the coating, and improving the adhesive properties of said layer with respect to the subjacent dielectric layer.

To enhance the radiation-protective effect of the coating, heat radiation inclusive, as well as to impart thereto wear- and corrosion-resistant, and decorative properties, it is desirable that, when two or more nonmetallic current-conducting layers are provided in the coating, said layers, save the innermost one, comprise nitrides of metals selected from the group consisting of titanium, chromium, tungsten, niobium, and zirconium.

According to the invention, at least one metallic current-conducting layer may be made of a metal or of an alloy of at least two metals selected from Groups I, II, III, IV, V, VI, VII, and VIII of the Periodic system.

When two or more metallic current-conducting layers are provided in the coating, some of said layers are made of a metal selected from Groups I, II, III, IV, V, VI, VII, and VIII, while the other layers are made of alloys of at least two of said metals.

Such a construction arrangement of the aforementioned metallic current-conducting layers establishes a complex of properties featuring high magnetic and electric components which are instrumental in enhancing the protective characteristics of the proposed material.

### Best Method of Carrying Out the Invention

The proposed material for radiation protection comprises a nonmetallic base provided with a current-conducting coating applied thereto and consisting of, e.g., one nonmetallic current-conducting layer and one metallic current-conducting layer. The innermost layer contacting the base is the nonmetallic one which consists of sulfides of metals selected from the group consisting of silver, copper, nickel, cobalt, iron, zinc, bismuth, cadmium, manganese, and chromium, and may be obtained as follows. The material is held in an ammonia solution of metal salts until complete wetting, whereupon the material is water-washed, then held in a solution of metal sulfides, and water-washed again.

The metallic current-conducting layer may comprise one of the following metals taken per se: nickel, copper, silver, cobalt, iron, gold, palladium, tin, lead, zinc, cadmium, chromium, and indium. Said layer is applied using electrolysis from electrolytes, containing ions of the respective metals, e.g., from a solution, containing 200 g/l of nickelous sulfate, 40 g/l of nickelous chloride, and 30 g/l of boric acid at 20°C and a current density of 1 A/sq.dm.

The metallic layer may be applied to the electroplated layer using some other techniques, e.g., chemical deposition from solutions, vacuum metal spray deposition, molten metal spray deposition, and others.

It is expedient that, depending on operating conditions and application of the material, the outer metallic layer is made of a required substance, such as:
- with a view to enhancing corrosion resistance of the material, the following coatings are applied: polyethylene, rubber, oxide, sulfide, chromate, aluminium, chromium, and others;
- in order to increase electric conductance of the material, one of the following layers is applied: copper, silver, golden, or aluminium;
- with the purpose of improved solderability a layer of a tin-lead alloy is applied;
- to improve heat-reflecting properties a layer of either aluminium or chromium is applied;
- to impart light-absorbing properties to the material, the following coatings are applied: sulfide, oxide, paintwork , or rubber;
- to add to wear resistance of the material, a layer of either chromium or titanium nitride is applied.

Used as a base material may be textile fabric, paper, film, as well as spongy and nonwoven synthetic materials.

Tabulated below are examples of various combinations of current-conducting layers of the fabric-based coating and the radiation-protective characteristics thereof.

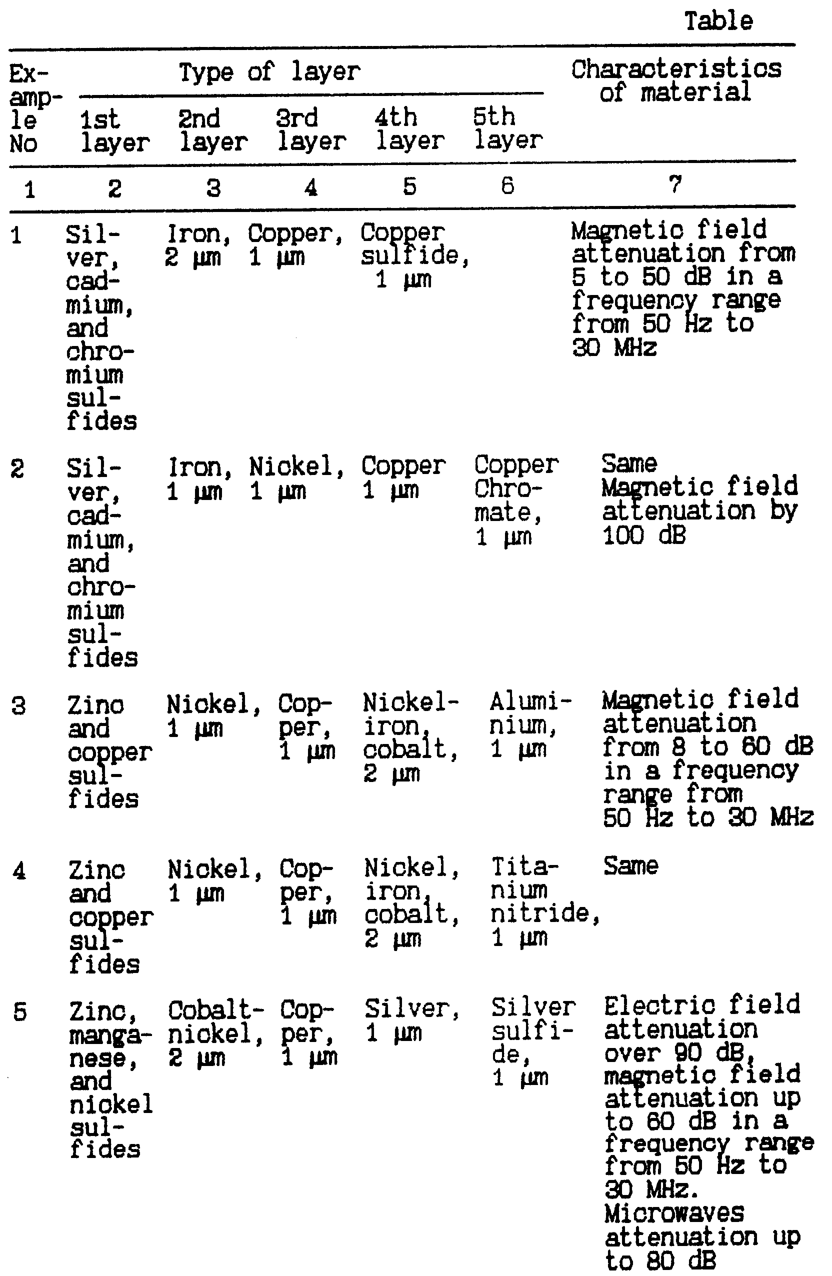

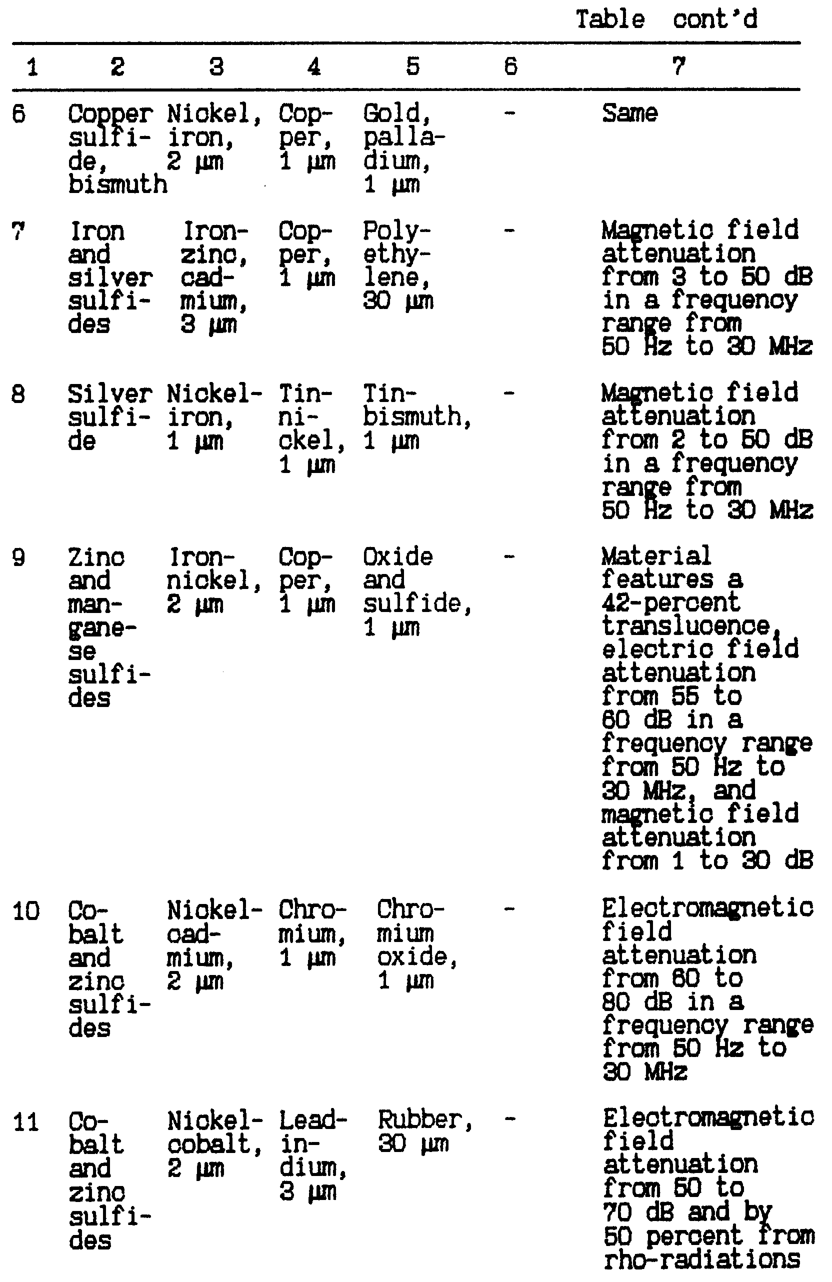

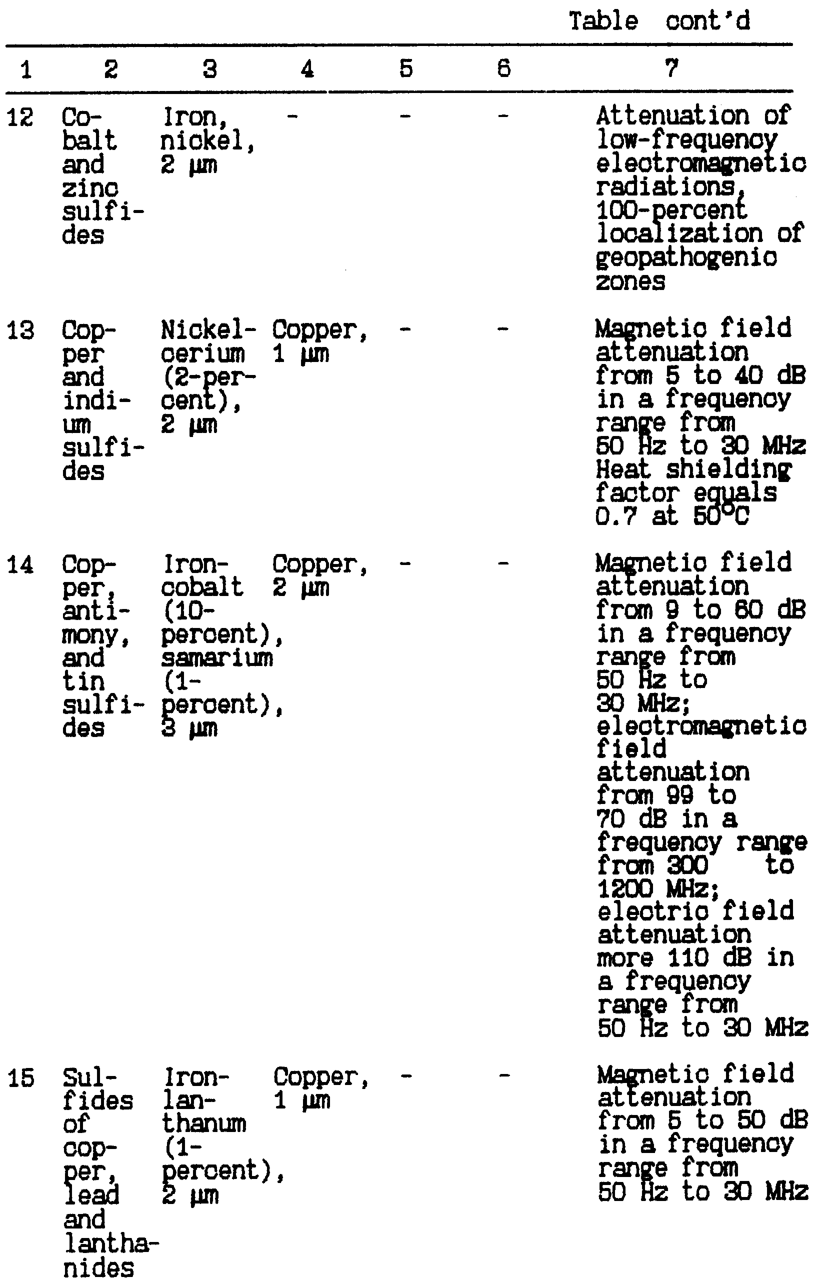

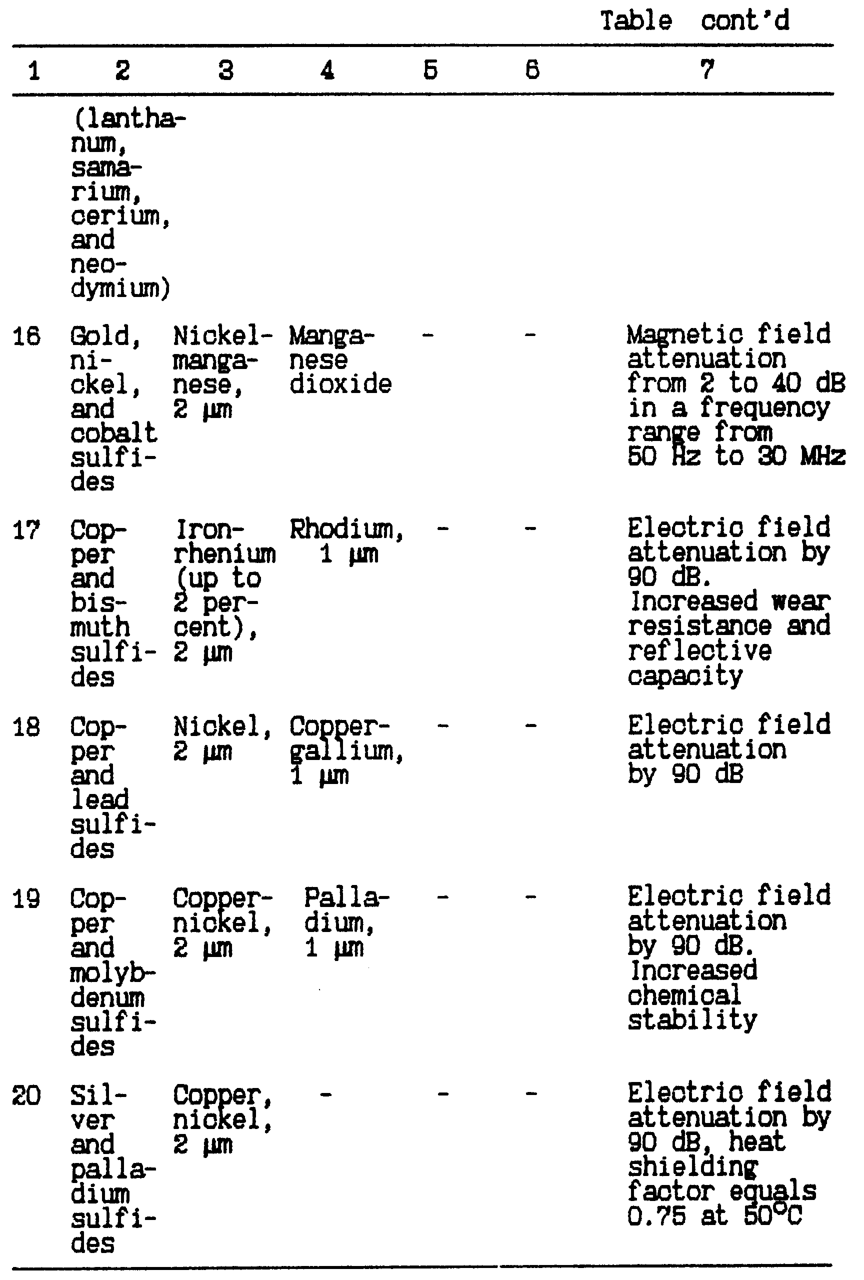

The table contains data on the various embodiments of the current-conducting coating. The number of layers in the coating in excess of five is virtually inexpedient due to increased laboriousness, as well as due to the fact that it is more expedient to increase the thickness of said coating layers for a further enhancement of the radiation protecting effect rather than to increase the number of layers in the coating. By and large the thickness of the protective coating may range from 0.5 to 100 µm and over; however, it is the material having a coating 2 to 15 µm thick that finds most widespread application, this being due to its adequate shield efficiency in conjunction with flexibility, permeability to air, transparency, low specific consumption of materials, and technological effectiveness.

In some instances only two current-conducting layers are sufficient, that is, one layer having a high electric resistance and the other layer having a low resistance (examples 12 and 20). Metallic coating may be applied in a number of layers, consisting of individual metals (Examples 1, 2, 3, 4, 5, 6, 7, 9, 10, 13, 14, 15, 17, 18, and 19), or of metal alloys (Examples 3, 4, 5, 6, 7, 8, 9, 10, 11, 12, 13, 14, 15, 16, 17, 18, 19, and 20), and said alloys may contain two or more metals. The coating may comprise some layers, consisting of individual metals and other layers, consisting of metal alloys (Examples 3, 4, 5, 6, 7, 9, 10, 13, 14, 15, 17, 18, and 19).

In Example 3 titanium or zirconium may be substituted for aluminium.

In Examples 1, 9, and 10 the coating contains four current-conducting layers of which two layers, that is, the innermost and the outermost ones are nonmetallic.

In Examples 4 and 5 the coating comprises five current-conducting layers of which two layers, that is, the innermost and the outermost ones are nonmetallic.

In Examples 2, 7, and 11 the outermost layer is nonconducting.

All nonmetallic current-conducting layers have an electric resistance in the range from 3 to 100,000 Ohm/sq.cm and the metallic current-conducting layers feature an electric resistance of from 0.001 to 1 Ohm/sq.cm.

The herein-proposed material is distinguished for:
- high protection characteristics against electromagnetic fields within a broad frequency range (50 Hz to 30 GHz);
- high reflective capacity of wide-range radio-frequencies at a 99-percent level;
- high electric conductance enabling use of the material in structures and products concerned with the problems of destaticization;
- high thermal protection against IR radiation;
- high technological and construction effectiveness in conjunction with low specific consumption of materials due to such properties inherent therein as flexibility, low weight, permeability to air, mechanical strength, high strength of adhesion to various dielectrics (rubber, polyethylene, foamed polyurethane, and others), as well as applicability of the material in hard-of-access places of various structures;
- resistance to corrosive media and temperature variation;
- possibility of using the material as a component in conjunction with diverse other materials in making, e.g., footwear, orthopedic one inclusive, and peepholes, thus providing simultaneous combination of tinting, warming, and radiation protection.

Furthermore, the material can readily stitched together, soldered, bonded together, and shaped; it also possesses therapeutic properties, is nontoxic, provides reliable protection against magnetic storms, and localizes geopathogenic zones. The herein-proposed material attenuates by more than 20 times a flux of electromagnetic radiations at a frequency of 60 Hz from the screens of video terminals with a 42-43 percent translucence.

### Industrial Applicability

The present invention can find utility when applied in/for:
- means for shielding industrial sources of harmful electromagnetic radiations, such as electronic and electrical devices and apparatus of various applications, e.g., transformers, repeaters, video terminals, generators, current-conducting cables in a wide range of frequencies, i.e., from the lowest to the microwave ones;
- means and devices for destaticization and preventing electrostatic discharges, e.g., in synthetic carpet and other floor coverings in living accommodations and production premises;
- means and devices for protecting people, as well as instrumentation, pipelines, and other equipment against heat radiation both from within and from without;
- devices and means for protecting people and instrumentation against intense electric and electromagnetic radiations, e.g., in the zones of high-voltage electric power lines, electric power stations and nuclear power plants, as well as near the radiators of sea- and airports and airfields;
- generating and receiving directional radiations in devices of, e.g., systems of communications means, such as satellite antennas, radars, repeaters, solar energy reflectors and receivers;
- means and devices of medical use, such as electrocardiograph and electroencephalograph electrodes, equipment for resuscitation and cardiovascular departments and wards, devices for treating pustular and weeping wounds, as undermattress draw-sheets, and floor mats for localizing geopathogenic zones;
- filters for display screens and overalls of operators of video terminals or those working with microwave facilities, various compression onlays for joints and muscles for arresting pain syndromes;
- means for protection against soft radiaoactive radiation in the form of blinds, curtains, cloaks, overalls, aprons, and upholstery;
- outfitting anechoic chambers and screened rooms, mobile laboratories, and other dismountable premises;
- designing various models of special-purpose sports clothing for, e.g., fencers, alpinists, and speleologists and using the proposed material therein;
- a base in making flexible printed circuits boards, electric heaters, and light-weight current-conducting cables and cords; and
- individual protection means in fire safety system.

## Claims

1. A material for radiation protection, comprising a nonmetallic base provided with a current-conducting coating applied thereto, CHARACTERIZED in that the current-conducting coating comprises at least one nonmetallic current-conducting layer and one metallic current-conducting layer, the nonmetallic layer being the one immediately contacting the nonmetallic base of the coating.

2. A material for radiation protection according to Claim 1, CHARACTERIZED in that it comprises additionally a nonmetallic nonconducting layer which is the outermost coating layer.

3. A material for radiation protection according to Claim 1, CHARACTERIZED in that the innermost nonmetallic current-conducting layer of the coating comprises the compounds of sulfides of metals selected from Groups I, II, III, IV, V, VI, VII, and VIII of the Periodic system.

4. A material for radiation protection according to Claim 1, CHARACTERIZED in that when two or more nonmetallic current-conducting layers are provided in the coating, said layers, save the innermost one, comprise metal oxides selected from the group consisting of copper, silver, tin, bismuth, lead, nickel, cobalt, iron, chromium, aluminium, manganese, indium, zinc, and antimony.

5. A material for radiation protection according to Claim 1, CHARACTERIZED in that when two or more nonmetallic current-conducting layers are provided in the coating, said layers, save the innermost one, comprise metal nitrides selected from the group consisting of titanium, chromium, tungsten, niobium, and zirconium.

6. A material for radiation protection according to Claim 1, CHARACTERIZED in that at least one metallic current-conducting layer is made of a metal selected from Groups I, II,III, IV, V, VI, VII, and VIII of the Periodic system.

7. A material for radiation protection according to Claim 1, CHARACTERIZED in that at least one metallic current-conducting layer is made of an alloy of at least two metals selected from Groups I, II, III, IV, V, VI, VII, and VIII of the Periodic system.

8. A material for radiation protection according to Claim 1, CHARACTERIZED in that when two or more metallic current-conducting layers are provided in the coating, some of said layers are made of a metal selected from Groups I, II, III, IV, V, VI, VII, and VIII of the Periodic system, and the other layers are made of alloys of at least two said metals.

9. A material for radiation protection according to Claim 1, CHARACTERIZED in that the nonmetallic nonconducting layer is made of a dielectric material.
